# EUROPEAN PATENT SPECIFICATION

(11) **EP 3 300 462 B1**
(45) Date of publication and mention of the grant of the patent: **11.12.2019**
(21) Application number: 16189964.6
(22) Date of filing: 21.09.2016
(51) Int. Cl.: H05K 1/02, H05K 1/11, H05K 1/18, H02M 7/00

(54) **CAPACITOR DC-LINK ARRANGEMENT**
KONDENSATOR-GLEICHSPANNUNGSZWISCHENKREISANORDNUNG
SYSTEME DE LIAISON A COURANT CONTINU DE CONDENSATEUR

(43) Date of publication of application: 28.03.2018
(73) Proprietor: Brose Fahrzeugteile GmbH & Co. Kommanditgesellschaft, Würzburg, 97076 Würzburg (DE); The Technical University of Cluj-Napoca, 400114 Cluj-Napoca (RO)
(72) Inventor: Teodosescu, Petre Dorel, Cluj Napoca (RO); Vintiloiu, Ioana, 97074 Würzburg (DE); Pop, Adrian Cornel, 97070 Würzburg (DE); Rusu, Tiberiu, 970761 Würzburg (DE); Pop-Piglesan, Florin-Adelin, Cluj Napoca (RO); Daramus, Mihai-Alexandru, Aiud (RO)
(74) Representative: Isarpatent

(56) References cited:
- WO-A1-2014/160265
- US-A1- 2005 024 813
- US-A1- 2010 254 108
- US-A1- 2014 367 154

## Description

### FIELD OF THE INVENTION

The present invention relates to a capacitor DC-link arrangement, in particular a capacitor DC-link arrangement for high current ripple applications.

### BACKGROUND OF THE INVENTION

Capacitor DC link arrangements are usually used in power conversion systems in order to balance instantaneous power differences between an input source and an output load and in order to minimize voltage variations.

The basic principle of such arrangements is explained e. g. in Huai Wang, Frede Blaabjerg, Reliability of Capacitors for DC-Link Applications in Power Electronic Converters-An Overview, IEEE TRANSACTIONS ON INDUSTRY APPLICATIONS, VOL. 50, NO. 5, SEPTEMBER/OCTOBER 2014.

Furthermore, documents US 8,138,042 B2 and US 2010/0290173 A1 also describe to use multi-layer ceramic capacitors (MLCC) in DC-link arrangements. Additionally, US 20120273265 A1 describes a printed circuit board (PCB) configured as computer motherboard with a multi-layer ceramic capacitor array.

Ceramic capacitors are suitable for DC-link arrangements in low voltage applications, since this type of capacitor technology is capable to handle high current ripple at low capacitance. However, these capacitors cannot incorporate high capacitance into one chip. Therefore, in high current applications it is vitally important not to exceed given current thresholds and/or specific temperature limitations, although in comparison with so called Al-Caps (Electrolytic capacitor technology) lower capacitance is needed.

Another important aspects arising from the use of the ceramic capacitors as DC-Link are the mechanical limitations in those environments with high vibration. In those environments mechanical damages of the capacitor body due to vibration stress is very often connected with an unwanted short-circuit of the capacitor. This is a scenario which should be avoided in any case.

The closest prior art document is US-A1-2014/367154. Other prior art documents are US-A1-2010/254108, US-A1-2005/024813,WO - A1-2014/160265.

### SUMMARY OF THE INVENTION

In view of the above, one object underlying the present invention is to provide an improved DC-link arrangement.

In accordance with the present invention, a capacitor DC-link arrangement, in particular for high current ripple applications is provided. The capacitor DC-link arrangement comprises a substrate such as a PCB-based substrate, a first terminal and a second terminal which are both arranged on the substrate, a plurality of ceramic capacitor elements, wherein: each of the ceramic capacitor elements is connected as well to the first terminal and the second terminal, the plurality of ceramic capacitor elements are connected in parallel, and the ceramic capacitor elements are arranged and connected in a similar current path and in particular in the same current path.

The basic principle of the present invention is based on the idea to provide a DC-link arrangement where a plurality of ceramic capacitor elements are connected in parallel such that same resistance, current paths are obtained for each capacitor elements.

In particular, each capacitor current path has the same resistance such that as a consequence of this current and/or electric charge is evenly distributed over all ceramic capacitor elements.

In particular, the current path resistance from positive end to negative end (via the first positive terminal and second negative terminal) is the same for all the ceramic capacitor elements.

This way, according to the invention, capacitor elements are advantageously loaded homogenously and symmetrically. Therefore, exceeding current and temperature limitations of single or certain capacitor elements, especially in high current applications, is prevented and preferably no capacitor element will be overloaded.

The capacitor DC-link arrangement according to the present invention can be used, for example, in electronic converters with input or output DC voltage, as standalone DC filtering array or in conjunction with inductive filtering. Other applications are certainly also possible.

According to an embodiment, the filtering can be made with only the ceramic capacitor bank.

In another embodiment, in particular in applications where high capacitance is needed, the arrangement may, in addition to ceramic capacitors, comprise electrolytic capacitors. Such a capacitor combination advantageously lowers the current ripple of the electrolytic capacitors

Advantageous or preferred features of the invention are recited in the dependent claims.

In a preferred embodiment, the first terminal and the second terminal each comprise a contact area (to which the terminals of the ceramic capacitor elements are connected to). At least one of the first and second terminals is split into at least a first path and a second path such to form at least a part of the corresponding contact area. In particular, at least a path of the contact area of the other one of the first and the second terminals extends between the first and second path. In this way, a high number of ceramic capacitor elements can be arranged in parallel along the first and second path. This allows an easy connection or contacting of a comparably high number of ceramic capacitor elements in parallel to each other and with a similar or preferably the same current path.

According to a preferred embodiment, the first and second paths are arranged in parallel. In particular, the main direction or extension of the paths is parallel. Borderlines of the paths may be, but are not necessarily all in parallel. Also, slight deviations from ideal parallelism, for example in an angle smaller than 10°, are possible so that also these configurations should be understood as covered by this language of this embodiment. The (more or less) parallel arrangement, advantageously, allows a very compact packaging and/or arrangement.

According to an advantageous embodiment, each of the first and second terminals comprises at least a first and a second path, wherein the first and second paths of the first and second terminals are, at least partially, arranged in parallel. In a further embodiment, more than two paths of one or both of the first and second terminals are possible.

In a particularly preferred embodiment, one of the first and second terminals comprises one more path than the other. In this way, a symmetrical arrangement of the paths and thus of the ceramic capacitor elements is possible, in particular also with a comparably high number of parallel ceramic capacitors.

According to an embodiment, the first terminal and/or the second terminal comprises an interconnecting section which is arranged and configured such to connect the first and second paths with each other. Preferably, both of the first and second terminals comprise a first and a second path and therefore each first and second terminal comprises an interconnecting section connecting the first and second paths. Preferably, the interconnection section runs perpendicular to the first and second paths. In particular, the first and/or second terminals have a fork-like or finger-like shape. Accordingly, it is divided into branches wherein each of the branches is forming a path. This way, as one particular advantage of the proposed topology, although a big number of ceramic capacitor elements are provided it is nevertheless possible to obtain quite the same current path resistance for each of the capacitor elements that are being connected in parallel to each other.

According to an especially advantageous embodiment, the DC-link arrangement further comprises a plurality of strengthening bus bars arranged on and/or along the contact areas. The strengthening bus bars can be configured for strengthening, straitening and/or stiffening the complete capacitor DC-link arrangement. This way, mechanical properties of the capacitor DC-link arrangement significantly are improved and damages, in particular capacitor body damages, e.g. due to application in high vibration environments can be prevented or at least significantly reduced.

In particular, the contact areas may comprise a solderable metal layer on the substrate, such as a copper layer. In particular, the substrate is a printed circuit board (PCB) and provided with a copper layout. This way, additional strengthening or straitening or stiffening metal bus bars can be soldered directly on the PCB layout.

According to an embodiment, at least a first strengthening bus bar is arranged on and/or along the first path and at least a second strengthening bus bar is arranged on and/or along the second path. In this way, the contact area is advantageously strengthened along both paths.

According to a further embodiment, at least a third strengthening bus bar is provided. The third strengthening bus bar is arranged on and/or along the interconnecting section. In this way, strengthening, straitening and/or stiffening is also provided in the lateral direction and in the interconnecting section next to and/or between the first and second paths.

According to an embodiment, the third strengthening bus bar is oriented perpendicular to the first and/or second strengthening bus bars. In this way, strengthening is provided in defined directions and/or dimensions.

According to an embodiment, the third strengthening bus bar is connected to the first and/or second strengthening bus bar. In this way, stiffening of the arrangement, in particular in the contact area, is further improved.

According to an embodiment, the substrate comprises a first side and a second side opposite to the first side, wherein the arrangement of contact areas is provided equally on both sides. This means, all elements of the capacitor DC-link arrangement are equally provided on the first side and on the second side. In this way, the capacity of the DC-link arrangement can be increased, in particular doubled. Further, a very compact design and/or package are possible.

According to an embodiment, the contact areas of the first terminal and the second terminal on the first side are connected to corresponding contact areas on the second side through the substrate. In particular, the direct connection is realized by means of through-holes or vias in the substrate. In this way, the mechanical properties of the array of ceramic capacitor elements are improved by the arrangement itself.

According to a preferred embodiment, the ceramic capacitor elements are configured as multi-layer ceramic capacitors. In this way, the DC-link arrangement can be used for high current ripple applications.

According to a typical embodiment, during operation the first terminal is configured to be the positive voltage point (connection)or positive electric potential. During operation, the second terminal is configured to be the negative voltage point (connection) or negative electric potential. Also the opposite configuration can be considered.

### BRIEF DESCRIPTION OF THE DRAWINGS

For a more complete understanding of the invention and the advantages thereof, exemplary embodiments of the invention are explained in more detail in the following description with reference to the accompanying drawing figures, in which like reference characters designate like parts and in which:
- Fig. 1: is a plan view on a DC-link arrangement according to a first embodiment;
- Fig. 2: is a sectional view of the DC-link arrangement of fig. 1;
- Fig. 3: is a plan view on a DC-link arrangement according to a second embodiment; and
- Fig. 4: is a sectional view of the DC-link arrangement of fig. 3.

The accompanying drawings are included to provide a further understanding of the present invention and are incorporated in and constitute a part of this specification. The drawings illustrate particular embodiments of the invention and together with the description serve to explain the principles of the invention. Other embodiments of the invention and many of the attendant advantages of the invention will be readily appreciated as they become better understood with reference to the following detailed description.

It will be appreciated that common and/or well understood elements that may be useful or necessary in a commercially feasible embodiment are not necessarily depicted in order to facilitate a more abstracted view of the embodiments. The elements of the drawings are not necessarily illustrated to scale relative to each other. It will further be appreciated that certain actions and/or steps in an embodiment of a method may be described or depicted in a particular order of occurrences while those skilled in the art will understand that such specificity with respect to sequence is not actually required. It will also be understood that the terms and expressions used in the present specification have the ordinary meaning as is accorded to such terms and expressions with respect to their corresponding respective areas of inquiry and study, except where specific meanings have otherwise been set forth herein.

### DETAILED DESCRIPTION OF EMBODIMENTS

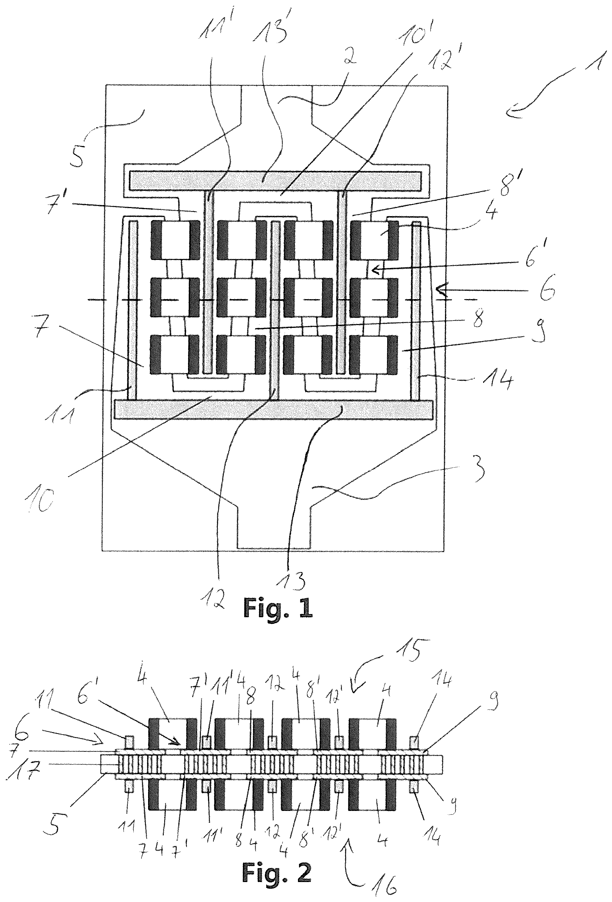

With reference firstly to Fig. 1 of the drawings, a plan view on a capacitor DC-link arrangement 1 according to a first embodiment is illustrated schematically.

The capacitor DC-link arrangement 1 comprises a substrate 5 which is in this case a printed circuit board (PCB). A first terminal 2 and a second terminal 3 are provided in form of copper layers on the substrate 5. Hereinafter, the first terminal 2 is a positive terminal 2 as during operation it is configured to be the positive voltage point (connection) and the second terminal 3 is a negative terminal 3 or reference terminal 3 as during operation it is configured to be the negative voltage point (connection).

The negative terminal 3 comprises a contact area 6 and the positive terminal 2 comprises a contact area 6'. These contact areas 6, 6' are configured in a fork-like form. The negative terminal 3 therefore comprises a first path 7, a second path 8 and a third path 9, which are interconnected by an interconnecting section 10. The positive terminal 2 comprises a first path 7' and a second path 8', which are interconnected by an interconnecting section 10'.

The different paths 7, 8, 9, 7' ,8' of both terminals 2, 3 are distanced from each other but are electrically in parallel to each other.

A plurality of ceramic capacitor elements 4, twelve of which are depicted in fig. 1 for example only, is connected to the positive and the negative terminal 2, 3 in the contact areas 6, 6' between the corresponding adjacent paths.

Since the negative terminal 3 comprises three paths 7, 8, 9 and the positive terminal 2 comprises two paths 7', 8' extending in parallel into a respective interspace between paths 7, 8, 9 of the negative terminal 3, there are in sum four pairs of adjacent borderlines of the corresponding parallel paths. Along each pair of borderlines, an exemplary number of three ceramic capacitor elements 4 configured as multilayer ceramic capacitor elements (MLCC) is arranged and connected to both respective paths of the positive terminal 2 and the negative terminal 3. Accordingly, all ceramic capacitor elements 4 are arranged and connected in a current path, which technically can be regarded as qualitatively same or same resistance current path.

Ceramic capacitor elements 4, in particular multilayer ceramic capacitors, are known by a skilled person and therefore not described in more detail herein. The ceramic capacitor elements 4 are soldered on the copper layers of the respective paths 7, 7', 8, 8', 9 and therefore fixed and electrically connected thereto.

In this way, a special arrangement of the ceramic capacitor elements 4 to obtain the same resistance current path for each of the capacitor elements 4 connected in parallel is provided. Accordingly, as one advantage of the proposed topology, load symmetry of the ceramic capacitor elements 4 is achieved.

Additionally, the arrangement 1 comprises a plurality of strengthening bus bars. A strengthening bus bar is fixed on each of the paths 7, 7', 8, 8', 9 and in parallel thereto. In addition, the interconnecting sections 10, 10' are provided with a strengthening bus bar.

In the present embodiment of fig. 1, the arrangement 1 on the negative terminal 3 comprises a first strengthening bus bar 11 fixed to the first path 7, a second strengthening bus bar 12 fixed to the second path 8, a third strengthening bus bar 13 fixed to the interconnecting section 10 perpendicular to the first and the second strengthening bus bars 11 and 12, and a fourth strengthening bus bar 14 fixed to the third path 9 in parallel to the first and second strengthening bus bars 11, 12.

On the positive terminal 2, the arrangement 1 comprises a first strengthening bus bar 11' fixed to the first path 7', a second strengthening bus bar 12' fixed to the second path 8', and a third strengthening bus bar 13' fixed to the interconnecting section 10' perpendicular to the first and the second strengthening bus bars 11' and 12'.

In this way, another advantage related with increased cracking vibration immunity of the capacitor bank is achieved by special arrangement of the ceramic capacitor elements 4 together with placing of the strengthening bus bars on the positive and negative copper paths. In particular, the strengthening bus bars are configured as metal bars and soldered on the copper paths. Thus, the typical fault found on the MLCC technology usually caused by vibrations, which is the damage of the capacitor body, is prevented.

The numbering of the paths and the strengthening bus bars of the positive terminal 2 has been described equal to, but may also be different from, the numbering of the path and strengthening bus bars of the negative terminal 3. An alternative, numbering of the corresponding elements of the positive terminal 2 may be fourth path 7', fifth path 8', fifth strengthening bus bar 11', sixth strengthening bus bar 12' and seventh strengthening bus bar 13'.

Fig. 2 is a sectional view of the DC-link arrangement of fig. 1 and shows that the substrate 5 comprises a first side 15, which is shown in Fig. 1, and an opposite second side 16, which is not shown in Fig. 1.

The complete arrangement of the contact areas 6, 6' of the positive and the negative terminals 2, 3 of the first side 15 is provided equally in the same manner on the second side. This means, all elements mounted on the substrate 5 as described with respect to fig. 1 are equally provided on the second side 16.

In addition, all elements including the interconnecting section 10 and the paths 7, 8 of the negative terminal 3 of the first side 15 are connected to the corresponding elements on the second side 16. For example, first path 7 of the first side 15 is connected to the first path 7 of the second side 16 and second path 8 of the first side 15 is connected to the second path 8 of the second side 16. Furthermore, strengthening bus bars are soldered on the paths 7, 8 on both sides 15, 16.

In the same manner, the elements of the positive terminal 2 of the first side are connected to the corresponding elements on the second side 16.

Connection of these elements is realized by means of through holes via 17, which are provided through the substrate 5. These through holes via 17, on one hand, provide for electrical connections of the corresponding elements and on the other hand provide for additional strengthening and stiffening of the arrangement.

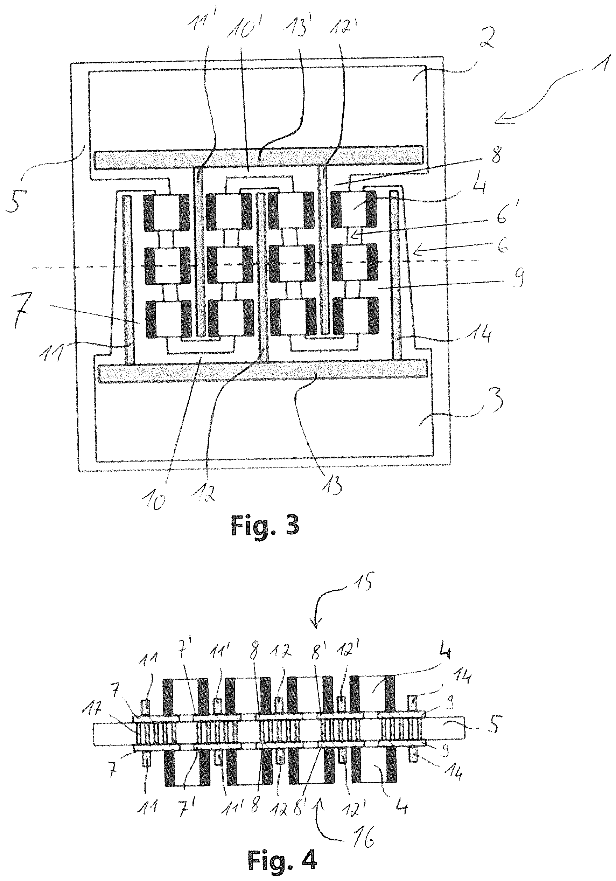

Fig. 3 is a plan view on a DC-link arrangement according to a second embodiment.

Fig. 3 has a slightly bigger scale compared to Fig. 1 and the second embodiment differs from the first embodiment in that the package of all elements is closer. In particular, the paths are slimmer and arranged narrower adjacent each other. In this way, the current path of all ceramic capacitor elements 4 is shorter compared to the first embodiment.

Furthermore, while the arrangement of the first embodiment provides for a symmetric loading of the capacitors, in particular with a longer current path, the arrangement of the second embodiment still achieves a quasi-symmetrical arrangement, but the current path is shorter. In particular, according to the first embodiment, the current path starts from a definite point symmetrically positioned for both the negative and positive terminals, in this way the resistance of the terminal being the same for all the capacitors, while for the second embodiment the connection points by example can be the left part for the positive and negative terminals, in which case the current path resistance will be slightly smaller for the left side capacitors. However, if the positive and negative terminals have large surfaces (small resistance) than the capacitor system can be considered symmetrically loaded.

Fig. 4 is a sectional view of the DC-link arrangement of fig. 3.

Similar to the first embodiment, the second embodiment also has a double sided arrangement 1. Thus, as explained with reference to Fig. 2, the complete arrangement of the contact areas 6, 6' of the positive and the negative terminals 2, 3 of the first side 15 is provided equally on the second side 16 in the same manner.

Accordingly, a strengthening bus bars arrangement for proper protection of the ceramic capacitor bank against vibrations is provided in the same manner by soldering of metal bars on the positive and negative copper layers of the terminals 2, 3 on both sides 15 and 16 forming a top and bottom layer on the substrate.

Although specific embodiments of the invention are illustrated and described herein, it will be appreciated by those of ordinary skill in the art that a variety of alternate and/or equivalent implementations exist. It should be appreciated that the exemplary embodiment or exemplary embodiments are examples only and are not intended to limit the scope, applicability, or configuration in any way. Rather, the foregoing summary and detailed description will provide those skilled in the art with a convenient road map for implementing at least one exemplary embodiment, it being understood that various changes may be made in the function and arrangement of elements described in an exemplary embodiment without departing from the scope as set forth in the appended claims

### LIST OF REFERENCE SIGNS

- 1: capacitor DC-link arrangement
- 2: first (positive) terminal
- 3: second (negative) terminal
- 4: ceramic capacitor element
- 5: substrate, PCB
- 6, 6': contact area
- 7, 7': first path
- 8, 8': second path
- 9: third path
- 10, 10': interconnecting section
- 11, 11': first strengthening bus bar
- 12, 12': second strengthening bus bar
- 13, 13': third strengthening bus bar
- 14: fourth strengthening bus bar
- 15: first side
- 16: second side
- 17: through hole, via

## Claims

1. Capacitor DC-link arrangement (1), in particular for high current ripple applications, the capacitor DC-link arrangement (1) comprising:
a substrate (5) such as a PCB-based substrate (5),
a first terminal (2) and a second terminal (3) which are both arranged on the substrate (5),
wherein the first terminal (2) and the second terminal (3) each comprise a contact area (6; 6') to which the terminals of the ceramic capacitor elements (4) are connected,
a plurality of ceramic capacitor elements (4), wherein:
- each of the ceramic capacitor elements (4) is connected as well to the first terminal (2) and the second terminal (3),
- the plurality of ceramic capacitor elements (4) are connected in parallel,
- the ceramic capacitor elements (4) are arranged and connected in a similar current path, and
a plurality of strengthening bus bars (11, 12, 13; 11', 12', 13'), wherein the strengthening bus bars (11, 12, 13; 11', 12', 13') are arranged on and/or along the contact areas (6; 6').

2. Capacitor DC-link arrangement according to claim 1, wherein at least one of the first and second terminals (2; 3) is split into at least a first path (7; 7') and a second path (8; 8') such to form at least a part of the corresponding contact area (6; 6').

3. Capacitor DC-link arrangement according to claim 2, wherein the first and second paths (7, 8; 7', 8') are arranged in parallel.

4. Capacitor DC-link arrangement according to claim 2 or claim 3, wherein each of the first and second terminals (2, 3) comprises at least a first and a second path (7, 8; 7', 8'), wherein the first and second paths (7, 8, 7', 8') of the first and second terminals (2, 3) are arranged in parallel along at least a section of the path.

5. Capacitor DC-link arrangement according to any of the claims 2 to 4, wherein the first terminal (2) and/or the second terminal (2) comprises an interconnecting section (10; 10') which is arranged and configured such to connect the first and second paths (7, 8; 7', 8') with each other.

6. Capacitor DC-link arrangement according to claim 1, wherein at least a first strengthening bus bar (11; 11') is arranged on and/or along the first path (7; 7') and at least a second strengthening bus bar (12; 12') is arranged on and/or along the second path (8; 8').

7. Capacitor DC-link arrangement according to claim 1 or claim 7, wherein at least a third strengthening bus bar (13; 13') is provided which is arranged on and/or along the interconnecting section (10; 10').

8. Capacitor DC-link arrangement according to claim 7, wherein the third strengthening bus bar (13; 13') is oriented perpendicular to the first and/or second strengthening bus bars (11, 12; 11', 12').

9. Capacitor DC-link arrangement according to claim 7 or claim 9, wherein the third strengthening bus bar (13, 13') is connected to the first and/or second strengthening bus bar (11, 12; 11', 12').

10. Capacitor DC-link arrangement according to any of the claims 2 to 9, wherein the substrate (5) comprises a first side (15) and a second side (16) opposite to the first side (15), wherein the contact areas (6, 6') are arranged equally on both sides (15, 16).

11. Capacitor DC-link arrangement according to claim 10, wherein the contact areas (6, 6') of the first terminal (2) and the second terminal (3) on the first side (15) are connected to corresponding contact areas (6, 6') on the second side (15) via through-holes via (17) provided in the substrate (5).

12. Capacitor DC-link arrangement according to any of the preceding claims, wherein the ceramic capacitor elements (4) are configured as multi-layer ceramic capacitors.

13. Capacitor DC-link arrangement according to any of the preceding claims, wherein the first terminal (2) is configured to be the positive voltage point or positive electric potential during operation and wherein the second terminal (3) is configured to be the negative voltage point or negative electric potential.

## Patentansprüche

1. Kondensator-Gleichstromzwischenkreisanordnung (1), insbesondere für Hochstrom-Ripple-Anwendungen, wobei die Kondensator-Gleichstromzwischenkreisanordnung (1) umfasst:
ein Substrat (5), wie beispielsweise ein PCB-basiertes Substrat (5),
einen ersten Anschluss (2) und einen zweiten Anschluss (3), die beide auf dem Substrat (5) angeordnet sind,
wobei der erste Anschluss (2) und der zweite Anschluss (3) jeweils eine Kontaktfläche (6; 6') aufweisen, mit der die Anschlüsse der keramischen Kondensatorelemente (4) verbunden sind,
mehrere keramische Kondensatorelemente (4), wobei:
- jedes der keramischen Kondensatorelemente (4) ebenfalls mit dem ersten Anschluss (2) und dem zweiten Anschluss (3) verbunden ist,
- mehrere keramische Kondensatorelemente (4) parallel geschaltet sind,
- die keramischen Kondensatorelemente (4) in einem ähnlichen Strompfad angeordnet und verbunden sind, und
mehrere verstärkende Sammelschienen (11, 12, 13; 11', 12', 12', 13'), wobei die verstärkenden Sammelschienen (11, 12, 13; 11', 12', 13') auf und/oder entlang den Kontaktflächen (6; 6') angeordnet sind.

2. Kondensator-Gleichstromzwischenkreisanordnung nach Anspruch 1, wobei mindestens einer der ersten und zweiten Anschlüsse (2; 3) in mindestens einen ersten Pfad (7; 7') und einen zweiten Pfad (8; 8') unterteilt ist, dergestalt, dass mindestens ein Teil der entsprechenden Kontaktfläche (6; 6') gebildet wird.

3. Kondensator-Gleichstromzwischenkreisanordnung nach Anspruch 2, wobei der erste und der zweite Pfad (7, 8; 7', 8') parallel angeordnet sind.

4. Kondensator-Gleichstromzwischenkreisanordnung nach Anspruch 2 oder Anspruch 3, wobei jeder des ersten und des zweiten Anschlusses (2, 3) mindestens einen ersten und einen zweiten Pfad (7, 8; 7', 8') umfasst, wobei der erste und der zweite Pfad (7, 8, 7', 8') des ersten und des zweiten Anschlusses (2, 3) parallel entlang mindestens eines Abschnitts des Pfades angeordnet sind.

5. Kondensator-Gleichstromzwischenkreisanordnung nach einem der Ansprüche 2 bis 4, wobei der erste Anschluss (2) und/oder der zweite Anschluss (2) einen Verbindungsabschnitt (10; 10') umfassen, der so angeordnet und ausgebildet ist, dass der ersten und der zweite Pfad (7, 8; 7', 8') miteinander verbunden werden.

6. Kondensator-Gleichstromzwischenkreisanordnung nach Anspruch 1, wobei mindestens eine erste verstärkende Sammelschiene (11; 11') auf und/oder entlang dem ersten Pfad (7; '7') angeordnet ist und mindestens eine zweite verstärkende Sammelschiene (12; 12') auf und/oder entlang dem zweiten Pfad (8; 8') angeordnet ist.

7. Kondensator-Gleichstromzwischenkreisanordnung nach Anspruch 1 oder Anspruch 7, wobei mindestens eine dritte verstärkende Sammelschiene (13; 13') vorhanden ist, die an und/oder entlang dem Verbindungsabschnitt (10; 10') angeordnet ist.

8. Kondensator-Gleichstromzwischenkreisanordnung nach Anspruch 7, wobei die dritte verstärkende Schiene (13; 13') senkrecht zu der ersten und/oder der zweiten verstärkenden Schiene (11, 12; 11', 12') ausgerichtet ist.

9. Kondensator-Gleichstromzwischenkreisanordnung nach Anspruch 7 oder Anspruch 9, wobei die dritte verstärkende Schiene (13, 13') mit der ersten und/oder der zweiten verstärkenden Schiene (11, 12; 11', 12') verbunden ist.

10. Kondensator-Gleichstromzwischenkreisanordnung nach einem der Ansprüche 2 bis 9, wobei das Substrat (5) eine erste Seite (15) und eine zweite Seite (16) gegenüber der ersten Seite (15) umfasst, wobei die Kontaktflächen (6, 6') gleichmäßig auf beiden Seiten (15, 16) angeordnet sind.

11. Kondensator-Gleichstromzwischenkreisanordnung nach Anspruch 10, wobei die Kontaktflächen (6, 6') des ersten Anschlusses (2) und des zweiten Anschlusses (3) auf der ersten Seite (15) mit entsprechenden Kontaktflächen (6, 6') auf der zweiten Seite (15) über ein in dem Substrat (5) ausgebildetes Durchkontaktierungsloch (17) verbunden sind.

12. Kondensator-Gleichstromzwischenkreisanordnung nach einem der vorangehenden Ansprüche, wobei die keramischen Kondensatorelemente (4) als Mehrschicht-Keramikkondensatoren ausgebildet sind.

13. Kondensator-Gleichstromzwischenkreisanordnung nach einem der vorangehenden Ansprüche, wobei der erste Anschluss (2) so ausgebildet ist, dass er der positive Spannungspunkt oder das positive elektrische Potenzial während des Betriebs ist, und wobei der zweite Anschluss (3) so ausgebildet ist, dass er der negative Spannungspunkt oder das negative elektrische Potenzial ist.

## Revendications

1. Agencement de liaison à courant continu (CC) à condensateurs (1), en particulier pour des applications à ondulation de courant élevée, l'agencement de liaison CC à condensateurs (1) comprenant :
un substrat (5) tel qu'un substrat basé sur une carte de circuit imprimé (5),
une première borne (2) et une deuxième borne (3) qui sont toutes deux disposées sur le substrat (5),
la première borne (2) et la deuxième borne (3) comprenant chacune une zone de contact (6 ; 6') à laquelle les bornes des éléments condensateurs céramiques (4) sont connectées,
une pluralité d'éléments condensateurs céramiques (4), dans laquelle :
- chacun des éléments condensateurs céramiques (4) est connecté aussi bien à la première borne (2) qu'à la deuxième borne (3),
- la pluralité d'éléments condensateurs céramiques (4) sont connectés en parallèle,
- les éléments condensateurs céramiques (4) sont disposés et connectés dans un trajet de courant similaire et
une pluralité de barres omnibus de renforcement (11, 12, 13 ; 11', 12', 13'), les barres omnibus de renforcement (11, 12, 13 ; 11', 12', 13') étant disposées sur et/ou le long des zones de contact (6 ; 6').

2. Agencement de liaison CC à condensateurs selon la revendication 1, dans lequel au moins l'une des première et deuxième bornes (2 ; 3) est divisée en au moins un premier trajet (7 ; 7') et un deuxième trajet (8 ; 8') de manière à former au moins une partie de la zone de contact correspondante (6 ; 6').

3. Agencement de liaison CC à condensateurs selon la revendication 2, dans lequel les premier et deuxième trajets (7, 8 ; 7', 8') sont disposés en parallèle.

4. Agencement de liaison CC à condensateurs selon la revendication 2 ou la revendication 3, dans lequel chacune des première et deuxième bornes (2, 3) comprend au moins un premier et un deuxième trajet (7, 8 ; 7', 8'), les premier et deuxième trajets (7, 8, 7', 8') des première et deuxième bornes (2, 3) étant disposés en parallèle sur au moins une section du trajet.

5. Agencement de liaison CC à condensateurs selon l'une quelconque des revendications 2 à 4, dans lequel la première borne (2) et/ou la deuxième borne (2) comprend une section d'interconnexion (10 ; 10') qui est disposée et configurée de manière à connecter les premier et deuxième trajets (7, 8 ; 7', 8') entre eux.

6. Agencement de liaison CC à condensateurs selon la revendication 1, dans lequel au moins une première barre omnibus de renforcement (11 ; 11') est disposée sur et/ou le long du premier trajet (7 ; 7') et au moins une deuxième barre omnibus de renforcement (12 ; 12') est disposée sur et/ou le long du deuxième trajet (8 ; 8').

7. Agencement de liaison CC à condensateurs selon la revendication 1 ou la revendication 7, dans lequel il est prévu au moins une troisième barre omnibus de renforcement (13 ; 13') qui est disposée sur et/ou le long de la section d'interconnexion (10 ; 10').

8. Agencement de liaison CC à condensateurs selon la revendication 7, dans lequel la troisième barre omnibus de renforcement (13 ; 13') est orientée perpendiculairement aux première et/ou deuxième barres omnibus de renforcement (11, 12 ; 11', 12').

9. Agencement de liaison CC à condensateurs selon la revendication 7 ou la revendication 9, dans lequel la troisième barre omnibus de renforcement (13, 13') est connectée à la première et/ou la deuxième barre omnibus de renforcement (11, 12 ; 11', 12').

10. Agencement de liaison CC à condensateurs selon l'une quelconque des revendications 2 à 9, dans lequel le substrat (5) comprend un premier côté (15) et un deuxième côté (16) opposé au premier côté (15), les zones de contact (6, 6') étant disposées de manière égale des deux côtés (15, 16).

11. Agencement de liaison CC à condensateurs selon la revendication 10, dans lequel les zones de contact (6, 6') de la première borne (2) et de la deuxième borne (3) du premier côté (15) sont connectées à des zones de contact correspondantes (6, 6') du deuxième côté (15) par des trous d'interconnexion traversants (17) prévus dans le substrat (5) .

12. Agencement de liaison CC à condensateurs selon l'une quelconque des revendications précédentes, dans lequel les éléments condensateurs céramiques (4) sont configurés sous la forme de condensateurs céramiques multicouches.

13. Agencement de liaison CC à condensateurs selon l'une quelconque des revendications précédentes, dans lequel la première borne (2) est configurée pour être le point de tension positive ou le potentiel électrique positif pendant le fonctionnement et dans lequel la deuxième borne (3) est configurée pour être le point de tension négative ou le potentiel électrique négatif.
